# EUROPEAN PATENT SPECIFICATION

(11) **EP 2 778 813 B1**
(45) Date of publication and mention of the grant of the patent: **27.12.2023**
(21) Application number: 14159622.1
(22) Date of filing: 13.03.2014
(51) Int. Cl.: G05B 19/042, H05K 7/14

(54) **Systems and methods for programming a plurality of motor drives**
Systeme und Verfahren zur Programmierung einer Vielzahl von Motorantrieben
Systèmes et procédés de programmation d'une pluralité de commandes de moteur

(30) Priority: 13.03.2013 US 201313801823
(43) Date of publication of application: 17.09.2014
(73) Proprietor: Rockwell Automation Technologies, Inc., Mayfield Heights, OH 44124 (US)
(72) Inventor: Braun, Scott D., Grafton, WI 53024 (US); Miller, Wanda J., Mequon, WI Wisconsin 53092 (US); Steinweg, Calvin C., Hartford, WI Wisconsin 53027 (US)
(74) Representative: Grünecker Patent- und Rechtsanwälte PartG mbB

(56) References cited:
- EP-A2- 2 169 488
- US-A1- 2005 075 758
- US-A1- 2010 100 198

## Description

The invention relates generally to the field of electrical power converters and inverters. More particularly, the invention relates to systems and methods for programming a plurality of motor drives.

Power inverters and converters typically employ power modules to create a desired output voltage waveform, which is used to power various devices, such as motors and other equipment. Power modules such as motor drives are generally manufactured to be suitable for a wide range of applications. Therefore, a typical motor drive may include general-purpose hardware and software components that provide the motor drive with a high degree of versatility. Before putting the motor drive into service, the motor drive may be custom programmed with the desired operating characteristics. The programming of the motor drive may be accomplished by providing several operating parameters that are customized to obtain the performance desired for the specific application. In some cases, the motor drive may be programmed by the motor drive manufacturer, the user of the motor drive, an original equipment manufacturer (OEM), system integrator, or other service provider. During its lifetime, a typical motor drive may be re-programmed several times to adjust to emerging needs. Moreover, from time to time, a motor drive may need to be replaced, and programming on the outgoing drive transferred or re-entered into the new system.
US 2005/075758 A1 discloses an apparatus for reprogramming a programmed controller of a power driven wheelchair. To initiate the reprogramming process of a flash memory, a programming device is connected to a microcontroller. The microcontroller is already programmed to interface with a user interface to receive and respond to commands therefrom. The programming device like a general purpose personal computer may be loaded with an appropriate main program for the flash memory based on the product code and/or version code of the motor controller of the wheel chair.
EP 2 169 488 A2 discloses a human interface module for motor drive where a human interface module is communicatively coupled to the controller and configured to allow an operator of the motor drive to monitor and control the motor drive. The human interface module includes a memory port configured to receive a portable memory. The portable memory stores a programming configuration of the motor drive and can be inserted into the memory port of the human interface module.
US 2010/100198 A1 is a system for deman based functionalization of a motor control unit comprising a motor control unit and a data store having a plurality of functional modules each configured to perform one or more functions of the motor control unit. An access device accesses the data store and selects the functional modules and loads one of the functional modules into the motor control unit. The selection is based on a demand and the selective loading results in a flexibly customizable functionality of the motor control unit.
It is therefore the object of the present invention to provide an improved method and corresponding system for programming a plurality of motor drives.
This object is solved by the subject matter of the independent claims.
Preferred embodiments are defined by the dependent claims.

It may be advantageous, therefore, to provide an improved system and method for updating and/or installing a programming configuration of a motor drive.

### BRIEF DESCRIPTION

In a first embodiment, a method for programming a plurality of motor drives includes the features of independent claim 1.

In a second embodiment, a system for programming a plurality of motor drives includes the features of independent claim 5. In an example not part of the invention,

an example a method for programming a plurality of motor drives includes acquiring a configuration file on a workstation, in which the configuration file is indicative of a programming configuration of the plurality of motor drives. The method further includes communicatively coupling the workstation to a first motor drive, transferring the programming configuration to the first motor, decoupling the workstation and the first motor drive, communicatively coupling the workstation to a second motor drive, and transferring the programming configuration to the second motor drive.

### DRAWINGS

These and other features, aspects, and advantages of the present invention will become better understood when the following detailed description is read with reference to the accompanying drawings in which like characters represent like parts throughout the drawings, wherein embodiments form part of the invention, and examples do not form part of the invention:
FIG. 1 is a perspective view of a motor drive in accordance with an example of the present invention;
FIG. 2 is a perspective view of the improved HIM shown in FIG. 1, depicting a control network to which the HIM 14 may be coupled, in accordance with examples of the present invention;
FIG. 3 is a block diagram of the motor drive of FIG. 1, in accordance with examples of the present invention;
FIGS. 4-6 are block diagrams illustrating examples of using the improved HIM 14 to update, transfer, or otherwise manage the configurations, the operational codes, or various user interface components of the motor drive, in accordance with examples of the present invention;
FIG. 7 is a block diagram illustrating an embodiment used to update, transfer, or otherwise manage the configurations, the operational codes, or various user interface components of a plurality of motor drives in mass; example
FIG. 8 is a block diagram illustrating an example used to update, transfer, or otherwise manage the configurations, the operational codes, or various user interface components of a plurality of motor drives in series; and
FIG. 9 is a flow chart illustrating a method to update, transfer, or otherwise manage the configurations, the operational codes, or various user interface components of motor drives.

### DETAILED DESCRIPTION

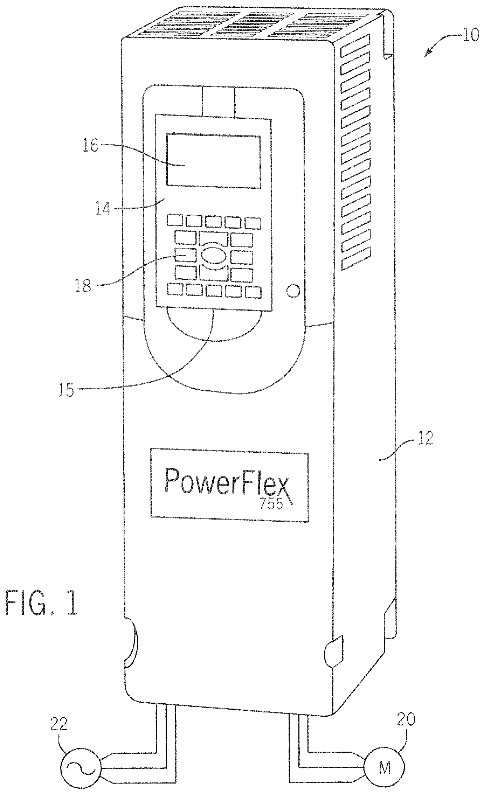

FIG. 1 is a perspective view of a motor drive 10 with an improved HIM 14, in accordance with examples of the present invention. In one example the motor drive 10 may be a PowerFlex drive manufactured by Rockwell Automation. The motor drive 10 may include a housing 12 having a receptacle 15 to hold a human interface module (HIM) 14.

To provide monitoring and/or control of the motor drive 10, the motor drive 10 may include a human interface module (HIM) 14. The HIM 14 may include a display 16, such as an LCD or other display device that may be used to provide feedback to the operator regarding the setting, performance or configuration of the motor drive 10. The HIM 14 may also include a keypad 18 allowing input by a user. The keypad 18 may be used to provide operator control of the motor drive 10, and may include various input structures, such as buttons, switches, touch pads, etc.

The HIM 14 may be attached to the motor drive 10 by placing it inside a receptacle 15 included in the housing 12 of the motor drive 10. In some examples the receptacle 15 may include a communications port that mates with the HIM 14, and placing the HIM 14 into the receptacle 15 may enable electronic communications between the HIM 14 and the motor drive 10. Conversely, decoupling the HIM 14 from the motor drive 10 may cause communication between the motor drive 10 and the HIM 14 to be deactivated. In other examples the motor drive 10 may also include a wireless communications device such as a Bluetooth^{®} device, to enable communication between the motor drive 10 and the HIM 14 even if the HIM 14 is not physically connected to the motor drive 10.

As described further below, the motor drive 10 is adapted to receive three-phase power from a power supply 22 and to convert the fixed frequency input power to controlled frequency output power to be applied to a motor 20. The power supply 22 may include a generator or an external power grid. Within the motor drive 10 may be disposed a variety of components or devices used in the operation and control of a load. As will be described further below, the operating characteristics of the drive 10 may be determined, in part, by a programming configuration of the drive 10. The programming configuration of the drive 10 may include any data, software, or firmware that is used to define the performance of the drive 10, the appearance or performance of the user interface of the drive 10, or the performance or user interface appearance of any peripheral devices communicatively coupled to the drive. As will be described further below, the programming configuration may include operating parameters, parameter customization data, and firmware for the drive or any peripherals. Often, certain aspects of the programming configuration will be determined by a manufacturer, OEM, system integrator, or other service provider and transferred to the motor drive 10 from an external source. Furthermore, periodic updates of the programming configurations or operational codes may take place, such as when a drive 10 is replaced, the drive 10 application is altered, or firmware is updated. As will be described further below, the improved HIM 14 may enable improved methods of updating the programming configurations or operational codes of the motor drive 10.

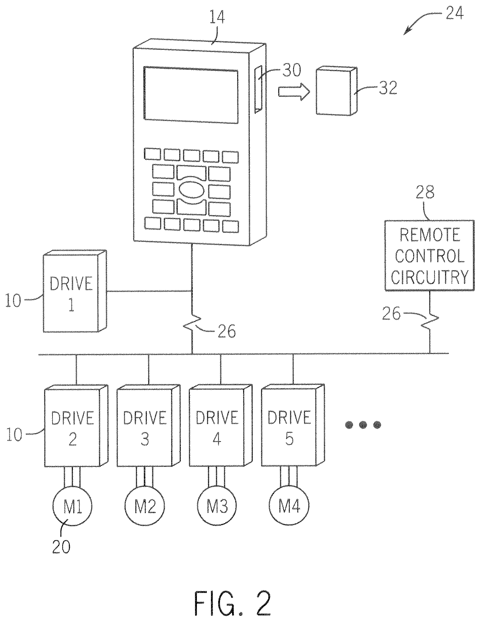

FIG. 2 is a perspective view of the HIM 14 shown in FIG. 1, depicting a control system 24 to which the HIM 14 may be coupled, in accordance with examples of the present invention. As shown in FIG. 2, the HIM 14 may be used to monitor or control any number of drives 10. For example, the HIM 14 may be communicatively and physically coupled to a first drive 10, as shown in FIG. 1. In addition, the HIM 14 may also be communicatively coupled to any number of additional drives 10 through a network 26. In this way, an operator may use a single HIM 14 to monitor and/or control an entire control system. The HIM of one drive may also access and capture some or all of the configuration parameters of other drives on the network, further facilitating updating or replacement of such other drives, as described below. Furthermore, the HIM 14 and the drives 10 may also be coupled through the network 26 to a remote control circuitry 40. The remote control circuitry 40 may be used to monitor and/or control the control system 24 from a remote location.

The HIM 14 may also include a memory port 30 for receiving a portable memory 32. The portable memory 32 may include any suitable computer memory, such as a flash memory card or USB flash drive, for example. In some: examples, the portable memory 32 may be a MicroSD^{™}, SD, CompactFlash, or other commercial off-the-shelf flash card available from various sources, such as SanDisk of Milpitas, California. As will be explained further below, the portable memory 32 may include one or more programming configurations or operational code sets for one or more motor drives 10. Additionally, the portable memory 32 may also include sets of measurement data collected from the drives 10.

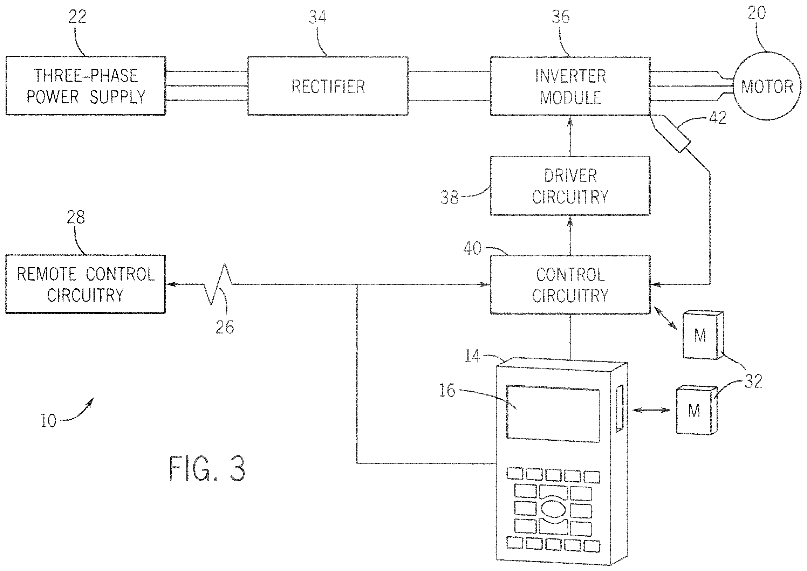

FIG.3 illustrates an exemplary motor drive 10 and provides additional details regarding the make-up of the motor drive 10. The motor drive 10 includes a rectifier 34 that receives a constant frequency three-phase voltage waveform from the power supply 22. Rectifier 34 performs full wave rectification of the three phase voltage waveform, outputting a direct current (DC) voltage to an inverter module 36.

Inverter module 36 accepts the positive and negative lines of DC voltage from the rectifier circuitry 34 and outputs a discretized three-phase waveform at a desired frequency, independent of the frequency of three-phase power supply 22. Driver circuitry 38 provides inverter module 36 with appropriate signals, enabling inverter module 36 to output the waveform. The resulting three-phase waveform may thereafter drive a load, such as a motor 20.

Control circuitry 40 may be coupled to the driver circuitry 38 and may be programmed to provide signals to the driver circuitry 38 for driving the motor 20. As discussed above, the control circuitry 40 may be programmed according to a specific drive configuration desired for a particular application. For example, the control circuitry 40 may be programmed to respond to external inputs, such as reference signals, alarms, command/status signals, etc. The external inputs may originate from one or more relays or other electronic devices. The programming of the control circuitry 40 may be accomplished through software configuration or firmware code that is loaded onto an internal memory of the control circuitry 40. The firmware of the control circuitry 40 may be configured to respond to a defined set of manipulable operating parameters. The settings of the various operating parameters determine the operating characteristics of the motor drive 10. For example, various operating parameters may determine the speed or torque of the motor 20 or may determine how the motor drive 10 responds to the various external inputs. As such, the operating parameters may be used to map I/O to control variables within the drive or to configure network or other drive options into the drive control variables. These variables include things like: speed presets, feedback types and values, computational gains and variables, algorithm adjustments, status and feedback variables, and PLC-like control programming.

In some examples, the motor drive 10 may include one or more sensors 42 for detecting operating temperatures, voltages, currents, etc. With feedback data from sensors 42, control circuitry 40 may keep detailed track of the various conditions under which inverter module 36 may be operating. The feedback data may be used to determine values for various feedback parameters, which may be displayed to the operator on the display 16 of the HIM 14. Additionally, the feedback data generated over time by the sensors 42 may be stored on the internal memory of the control circuitry 40, the HIM 14, or the portable memory 32.

The HIM 14 enables the operator to control the motor drive 10 by allowing the operator to manipulate the set of operating parameters programmed into the firmware of the control circuitry 40. The HIM 14 may also provide feedback to the operator, indicating motor drive 10 conditions such as actual motor speed, frequency, power, alarm conditions, etc. Accordingly, the display 16 may display the settings of some or all of the operating parameters of the drive 10. The appearance and functionality provided by the HIM 14 may be determined by software or firmware located in the HIM 14. The firmware of both the control circuitry 40 and the HIM 14 may be updated to incorporate new programming features or updates.

Additionally, the HIM 14 may be customized by the programmer to provide a more user friendly interface to the operator. In some examples, certain operating parameters may be customized by the programmer and displayed by the HIM 14 in terms that are more meaningful to the operator. For example, the motor drive 10 may be used in a production facility that manufactures items in a production line, and the speed of the motor may control the rate at which the items are produced. In that case, the HIM 14 may be programmed so that, rather than displaying a motor speed, the HIM 14 displays an item production rate corresponding with the motor speed. Accordingly, the programming configuration may include customized names associated with one or more operating parameters and displayed on the HIM 14 in place of the generic parameter name. Furthermore, the programmer may also limit the number of operating parameters that are accessible by the operator through the HIM 14. This parameter customization data may be included in the programming configuration of the drive.

In some cases, the programming configuration of the motor drive 10 may limit the functions available to the operator within certain suitable limits. In this way, the operator may control certain aspects of the motor drive 10, such as speed, without being allowed to change the basic timing requirements of the overall control system. Accordingly, some operating parameters may be accessible only to the programmer of the motor drive 10. Programmer accessible parameters may be manipulated by the programmer to customize the motor drive 10 for a particular control system application, while the operator accessible parameters allow the operator to control the everyday operation of the motor drive 10. In some examples, the firmware of the HIM 14 may be configured to allow the operator limited access to the full set of operating parameters programmed into the control circuitry 40. Through use of the HIM 14, the operator may manipulate the operating parameters of the motor drive 10 and change the functioning of the motor drive 10 accordingly, within the limits provided by the firmware on the HIM 14 or the control circuitry 40.

In some examples, the drive 10 may be communicatively coupled to one or more peripheral devices. For example, the drive 10 may be coupled to a communications module that allows communication with a network. The communications module may be programmed with certain firmware and may include various operating parameters, such as data rate, used to define the communication performance of the drive 10. The drive 10 may also include a feedback module that may include various encoders, resolvers, motion feedback sensors, etc. that may be used to provide feedback data to the drive 10. The drive 10 may also include digital or analogue input/output (I/O) peripherals, and enhanced safety board, for example. The peripheral devices may be included in an option card that is inserted into a communications port of the drive 10. All of the peripheral devices coupled to the drive 10 may be accessed through the HIM 14. As such, the HIM 14 may also obtain programming configuration, such as operating parameter information, and firmware, applicable to peripheral devices.

Setting or updating the programming configuration of the drive 10 may be accomplished using the portable memory 32 of the HIM 14. The portable memory 32 may include all or a portion of an entire motor drive 10 programming configuration, including the operating parameters applicable to the motor drive 10, firmware or firmware updates applicable to the HIM 14 or the control circuitry 40, and parameter customization data. The portable memory 32 may include programming configuration data for any peripheral devices that may be coupled to the drive. In some examples, the portable memory 32 may also be used to store historical trend data regarding the motor drive 10. For convenience, the present application describes the HIM 14 as including the portable memory 32. However, in some examples the control circuitry 40 may also include a memory port for receiving a portable memory 32 in addition to or instead of the HIM 14.

The control circuitry 40 may be configured to read the portable memory 32 to acquire the proper motor drive programming cconfiguration from the portable memory 32. An update of the drive programming configuration may include an update of some or all of the operating parameters of the motor drive 10, the firmware of the control circuitry 40, the firmware of the HIM 14, or some combination thereof. In some embodiments, the operator may initiate an update of the programming configuration of the drive 10 from the HIM 14. In other embodiments, the update may occur without operator input, in which ease the motor drive 10 may be configured to automatically acquire the programming configuration each time the motor drive 10 is powered up.

Upon acquiring a motor drive programming configuration from the portable memory 32, the motor drive programming configuration may be stored on the internal memory of the control circuitry 40. Thereafter, when the portable memory 32 is removed, the motor drive 10 will still retain the previously loaded programming configuration. Thus, if the portable memory 32 is not loaded into the HIM 14 or the control circuitry 40 is not communicatively coupled to the HIM 14, the control circuitry 40 may use the driver configuration already loaded in the internal memory of the control circuitry 40.

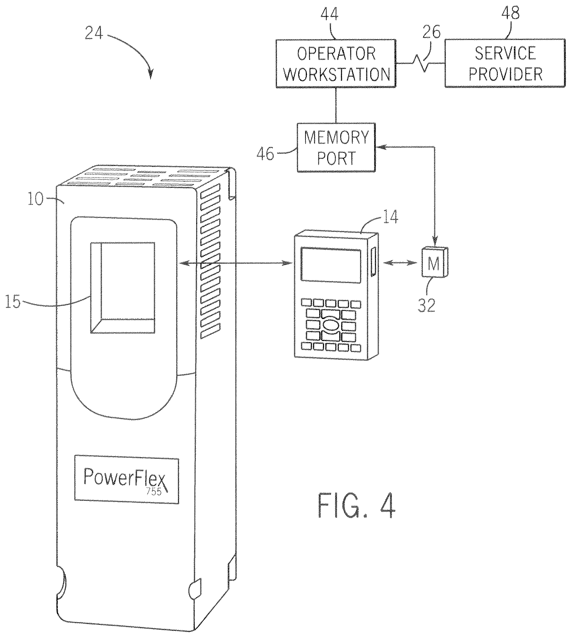

As will be discussed further, in relation to FIGS. 4-6, the use of the HIM 14 with the portable memory 32 enables a variety of methods for updating a configuration of the motor drive 10. For example, in one example, a drive configuration may be generated on a workstation or by a remote service provider, and the drive configuration may then be downloaded onto the portable memory 32 and plugged into the motor drive 10. Furthermore, multiple drives may be updated with multiple drive configurations using a single HIM 14 or portable memory 32. Additionally, drive configurations may be transferred directly between drives. The techniques disclosed herein also provide additional advantages. For example, the techniques disclosed herein enable the automatic updating of the drive configuration upon initial powering-up of the drive. For another example, the present techniques also allow a motor drive 10 to be updated without using additional, specialized hardware to perform the updates.

Turning now to FIGS. 4-6, several methods of using the improved HIM 14 to update the programming configuration of one or more motor drives 10 are depicted. Turning specifically to FIG. 4, a control system 24 for updating a motor drive 10 is depicted. The control system 24 may include a workstation 44, which may be any suitable computing device, including a personal computer or a mobile phone, for example. The workstation 44 may include or be coupled to a memory port 46 for receiving the portable memory 32 and enabling communication between the workstation 44 and the portable memory 32. In some examples, the workstation 44 may also be communicatively coupled to a network 26, which may include, for example, a Local Area Network (LAN) or Wide Area Network (WAN) and may allow connection to the Internet.

Several methods of generating or acquiring a motor drive programming configuration are enabled by the control system 24. In one example, the programming configuration of the motor drive 10 may be generated by a service provider 48 and transferred to the workstation 44 via the network 26. After receiving the programming configuration from the service provider 48, the operator of the workstation 44 may then use the workstation 44 to alter the programming configuration before loading the programming configuration onto the motor drive 10. For example, the workstation 44 operator may set the value of certain operating parameters used to customize the operating characteristics of the motor drive 10 for a particular usage. For another example, the workstation 44 operator may create parameter customization data used to define the appearance of the parameter data displayed to the operator. In another example, the programming configuration may be generated at the workstation 44, without involvement from the service provider 48. In yet another example, a programming configuration may be acquired from another drive 10 and uploaded to the workstation 44 through the memory port 46. In this way, a programming configuration for one drive 10 may be distributed to several motor drives 10.

After acquiring or generating the programming configuration, the user of the workstation 44 may then download the programming configuration to the portable memory 32 and insert the portable memory 32 into the HIM 14. After inserting the portable memory 32 into the HIM 14, the operator may communicatively couple the HIM 14 to the motor drive 10, such as by plugging the HIM 14 into the receptacle 15. At this time, the motor drive 10 has an updated programming configuration available and is ready to be placed into service. The next time the motor drive 10 is powered-up, the motor drive 10 may utilize the newly installed programming configuration.

In some examples, after the motor drive 10 is powered-up, the programming configuration may be loaded from the portable memory 32 into the memory of the control circuitry 40. Accordingly, powering-up the motor drive 10 may cause either the HIM 14 or the control circuitry 40 to compare the programming configuration of the control circuitry 40 and the programming configuration on portable memory 32. If a difference between the two is detected, the operator may be prompted by the HIM 14 to initiate the downloading and updating of the configuration file. In this way, the operator may preempt the programming configuration update and preserve the programming configuration already present on the control circuitry 40.

It should be noted that the programming configuration of the motor drive 10 may be set up to be updated with a new programming configuration when the portable memory 32 is loaded into HIM 14 and connected to the motor drive 10, regardless of whether the motor drive 10 is powered-up at the time the portable memory 32 is loaded into HIM 14. Because the motor drive 10 does not need to be powered up to add the HIM 14 containing the portable memory device 32, updating the motor drive 10 may be accomplished much more quickly and efficiently, and without the need of an available power source or specialized equipment at the origin of the update.

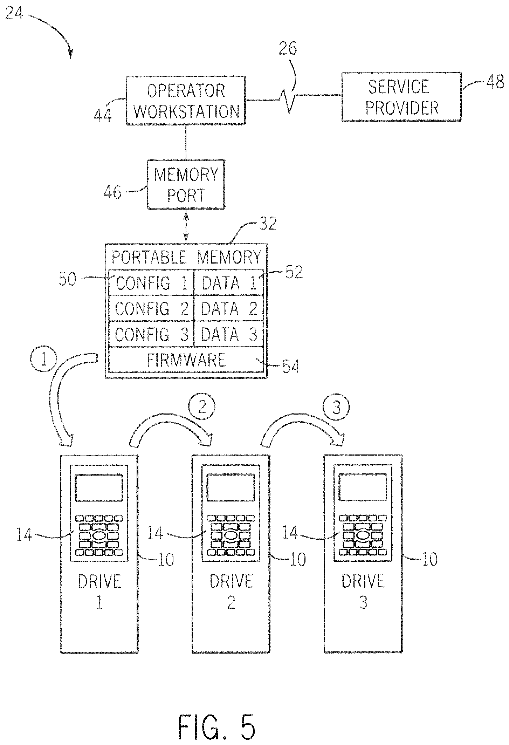

Turning to FIG. 5, a method of updating multiple motor drives 10 from a workstation 44 is shown. As discussed above, in relation to FIG. 4, the workstation 44 may be coupled to or include a memory port 46 for communicating with the portable memory 32 and may be coupled to a service provider 48 through the network 26. As shown in FIG. 5, the portable memory may include several data files applicable to several motor drives 10, such as, configuration files 50, log files 52, and the firmware file 54. The configuration files 50 may include parameter settings used by the control circuitry 40 for controlling the motor drive 10. The multiple configuration files 50 may include programming configurations for several drives 10 or alternate programming configurations for a single drive 10. The log files 52 may include parameter information corresponding with the operating conditions of a motor drive 10 measured over time, and may be useful in tracking, analyzing and troubleshooting the performance of a motor drive 10. The firmware file 54 may be a whole copy of a firmware program implemented in the control circuitry 40 or a partial update for a preexisting firmware program.

Using the portable memory 32 described above, several methods of updating a motor drive 10 or obtaining data from a motor drive 10 may be enabled. In the exemplary example shown in FIG. 5, a portable memory 32 is used to update several motor drives 10 that have the improved HIM 14. According to the depicted example, the portable memory 32 is inserted into a first motor drive 10, labeled "Drive 1." After the drive 10 is powered-up, the control circuitry 40 may obtain the configuration file 50 applicable to the specific drive. After the update is complete, the portable memory 32 may be removed from the HIM 14 of the first drive 10 without interrupting the operation of the first drive 10. The process may then be repeated for the remaining drives 10. Although three drives are depicted, the process maybe repeated for any number of drives 10. In this way, multiple drives 10 may be updated from one portable memory 32. Each of the drives 10 may be updated with the same configuration file 50 or each drive may be updated using a different configuration file 50. Additionally, rather than removing the portable memory 32 from the HIM 14 to perform the various updates, the entire HIM 14 may also be removed from the drive 10 and connected to each of the drives 10 to be updated. In this way, a single HIM 14 may be used to update several drives 10. The above process may also be used to update each drive 10 with the firmware file 54.

In addition to updating the drives 10, data may also be collected from the drives 10. After installing a HIM 14 with a portable memory 32 into a drive 10, the operator may store a log file 52 from the internal memory of the control circuitry 40 onto the portable memory 32. This storage of the log file 52 onto the portable memory 32 may be repeated for each drive 10. After collecting the log files 52, the operator may couple the portable memory 32 to the workstation through the memory port 46. From the workstation 44, the operator may analyze the log file 52 or may transmit the log file 52 to the service provider 48 for analysis. Additionally, in some examples, the HIM 14 itself may provide the capability of analyzing the log file 52.

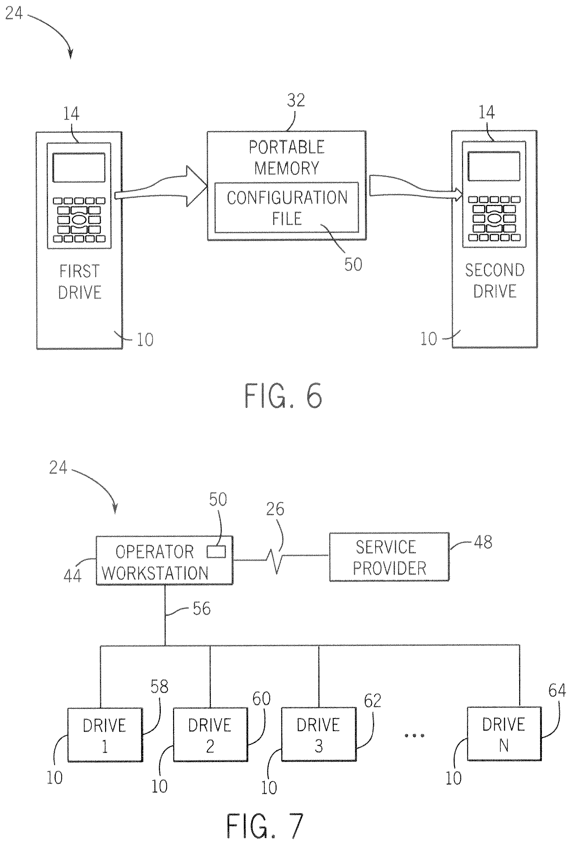

Turning now to FIG. 6, an exemplary method of transferring a drive configuration from one motor drive 10 to a second motor drive 10 is shown. As depicted in FIG. 6, the portable memory 32 may be removed from a first motor drive 10 and installed in a second motor drive 10. As discussed above, the portable memory 44 may include a configuration file 50, which may store the entire drive configuration of the first motor drive 10, including the full set of operating parameters and/or the firmware loaded into the control circuitry 40. This process may enable an operator of the motor drive 10 to quickly and efficiently replace the first drive 10 with a second drive 10 while maintaining the identical programming configuration. Furthermore, the use of the portable memory 32 enables the replacement to occur without powering-up either of the drive 10.

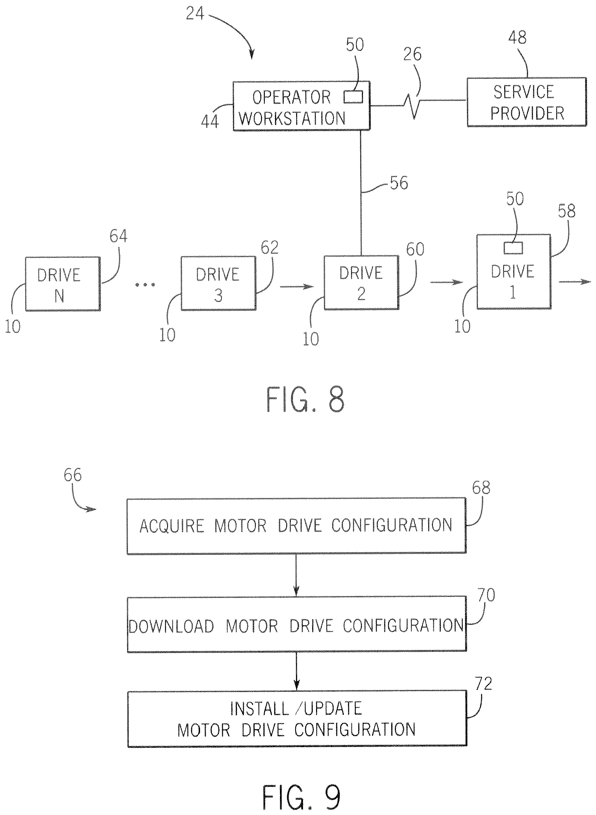

In addition to the examples depicted in FIGS. 4-6, FIG. 7 and FIG. 8 depict embodiments for installing and/or updating the programming configuration of a plurality of motor drives 10. As depicted, the examples in FIGS. 4-6 utilize the HIM 14 to communicatively couple the operator workstation 44 and the motor drives 10. Comparatively, the control systems 24 depicted in FIG. 7 and FIG. 8 may be a more general configuration to install and/or update the programming configuration of the plurality of motor drives 10, which programming may be "flashed" into the drives; that is, rapidly transmitted to memory devices in the drives for storing basic programming (e.g., basic motor drive functionality) or detailed programming (e.g., specific to an application, reseller, etc.). Accordingly, in some examples, the operator workstation 44 may be configured to directly install and/or update the programming configuration of the plurality of motor drives 10. As described above, this may be especially useful for an original equipment manufacturer (OEM) or a motor drive manufacturer. For example, to obtain a desired operating characteristic of the plurality of motor drives 10, an OEM may install and/or update the programming configuration of the plurality of motor drives 10 for application specific purposes, such as vector control or torque control in the motor drives 10. Accordingly, the programming configurations may configure variables such as speed presets, feedback types and values, computational gains and variables, algorithm adjustments, status and feedback variables, and PLC or automation controller-like control programming.

As depicted in FIG. 7 and FIG. 8, the workstation 44 is communicatively coupled through the network 26 to the service provider 48. As described above, the operator workstation 44 may generate and/or acquire a motor drive programming configuration through various methods. Similarly, the programming configuration may be in the form of a configuration file 50 and stored on the operator workstation 44. Once the operator workstation 44 acquires the configuration file 50, the plurality of motor drives 10 may be configured accordingly. Specifically, FIG. 7 depicts an embodiment for updating the plurality of motor drives 10 in mass. As depicted, the plurality of motor drives 10 is communicatively coupled to the operator workstation 44 through a communication apparatus 56. Similar to the example depicted in FIG. 2, the motor drives 10 may be communicatively coupled to the operator workstation 44 through a network 26. It should be appreciated that alternatively, the motor drives may be directly coupled to the operator workstation 44, for example, through serial cables.

As described above, a motor drive 10 may be configured to update its programming configuration based on the configuration file 50. Accordingly, in the embodiment depicted in FIG. 7, each of the plurality of motor drives 10 may be configured to update the programming configuration associated with motor drive based on the received configuration file 50, and the operator workstation 44 may be configured to transfer the configuration file 50 to each of the plurality of motor drives via the communication apparatus 56 (e.g., network 26 or serial cables). For example, in FIG. 7, Drive 1 58, Drive 2 60, Drive 3 62, and Drive N 64 may substantially simultaneously receive: the configuration file 50 from the operator workstation. 44 through the communication apparatus 56 and update their respective programming configuration. Alternatively, Drive 1 58, Drive 2 60, Drive 3 62, and Drive N 64 may receive the configuration file 50 from the operator workstation 44 one after another.

As an alternative to the embodiment depicted in FIG. 7, FIG. 8 depicts an example for updating the plurality of motor drives 10 in series. As depicted, one motor drive 10 is communicatively coupled to the operator workstation 44 at a time through a communication apparatus 56. Again, the communication apparatus may be a network 26, a serial cable, or the like. Similar to the embodiments described above, the operator work station 44 may be configured to transfer the configuration file 50 to the motor drive 10 communicatively coupled to it. Here again, the programming may be "flashed" into the drives, in a manner similar to the drive-to-drive transfer of programming summarized above. As such, the motor drive 10 may be configured to updates its programming configuration based on the configuration file 50. For example, in FIG. 8, Drive 2 60 is communicatively coupled to the operator workstation and receives the configuration file 50. Once Drive 2 60 has received the configuration file, it may be decoupled and Drive 3 62 may be communicatively coupled to the operator workstation 44 to receive the configuration file 50. This may be continued until Drive N 64 receives the configuration file. In addition, in the example depicted in FIG. 8, Drive 1 58 has already received the configuration file 50 and been decoupled from the operator workstation 44,

To better illustrate installing and/or updating a motor drive programming configuration, FIG. 9 depicts a general process 66 to install and/or update a programming configuration in a motor drive 10. The process 66 may begin by acquiring a motor drive programming configuration. In the embodiments described above, the programming configuration is acquired by the operator workstation 44. For example, the operator workstation may generate the programming configuration. Alternatively, in some examples, the motor drive 10 may itself acquire the programming configuration. In general, some or all of such programming configurations may relate to the very basic operation of the drives (e.g., communications protocols, techniques for diving the solid state switches, particular motor drive regimes, etc.). However, and particularly where implemented for specific applications (e.g., fan drives, conveyor drives, pump drives, etc.) or for particular OEM's, the programming configuration may include parameter designations, parameter settings, particular motion profiles, and a host of other programming that will be shared among the drives.

Next, the programming configuration may be downloaded/transferred to the motor drive 10. For example, in the examples depicted in FIGS. 4-6, this includes coupling flash memory or portable memory to the operator workstation 44 and transferring the programming configuration to the portable and/or flash memory. The flash memory may then be coupled to the HIM 14 and transfer the programming configuration to the HIM 14 and the motor drives 10. Alternatively, in the embodiments depicted in FIG. 7 and FIG. 8, this included communicatively coupling the motor drives 10 either in series or in mass to the operator workstation 44 and transferring the programming through a communication apparatus 56 to the motor drives 10. To help facilitate downloading/transferring the programming configuration to the motor drives 10, configuration files 50 indicative of the programming configuration may be used.

Finally, the motor drive 10 may install and/or update its programming configuration. As described above, the programming configuration of motor drives 10 may include firmware program, operator parameter settings, or any combination thereof. Accordingly, the motor drive 10 may be configured to update the programming configuration by adding to or replacing at least a portion of the existing programming configuration in the motor drive 10. In addition, in use by a motor drive manufacturer or an OEM, the motor drive 10 may be configured to install the programming configuration by adding the programming configuration to the motor drive 10. In some embodiments, the programming configuration of the motor drive 10 may be configured to be stored in the flash memory of the motor drive 10. As such, the programming configuration may be flashed into the Hash memory of the motor drive 10.

### Element List

- 10: motor drive
- 12: housing
- 14: human interface module (HIM)
- 15: receptacle
- 16: display
- 18: keypad
- 20: motor
- 22: power supply
- 24: control system
- 26: network
- 30: memory port
- 32: portable memory
- 34: rectifier
- 36: inverter module
- 38: driver circuitry
- 40: control circuitry
- 42: sensors
- 44: workstation
- 46: memory port
- 48: service provider
- 50: configuration files
- 52: log files
- 54: firmware file
- 56: communication apparatus
- 58: Drive 1
- 60: Drive 2
- 62: Drive 3
- 64: Drive 4
- 66: general process

## Claims

1. A method for programming a plurality of motor drives (10), said plurality of motor drives being adapted to receive three-phase power and to convert a fixed frequency input power to controlled frequency output power to be applied to a motor, comprising:
acquiring a configuration file (50) on a workstation (44), wherein the configuration file (50) is indicative of a programming configuration of the plurality of motor drives (10), wherein the programming configuration includes one or more configurations relating to the basic operation of the motor drives and one or more application specific configurations, wherein the one or more configurations relating to the basic operation of the motor drives include one or more of communication protocols, particular motor drive regimes and techniques for driving solid state switches, and wherein the one or more application specific configurations include parameter designations, parameter settings and particular motion profiles;
communicatively coupling the workstation (44) to the plurality of motor drives (10); and
transferring the programming configuration to each of the plurality of motor drives (10) communicatively coupled to the workstation (44), wherein transferring the programming configuration to each of the plurality of motor drives (10) comprises adding to or replacing at least a portion of the programming configuration of each of the plurality of motor drives (10), and wherein the programming configuration comprises operator parameter settings.

2. The method of claim 1, wherein transferring the programming configuration to each of the plurality of motor drives (10) comprises flashing the programming configuration into a flash memory (32) of each of the plurality of motor drives (10).

3. The method of claim 1, wherein transferring the programming configuration to each of the plurality of motor drives (10) comprises installing the programming configuration on each of the plurality of motor drives (10).

4. The method of claim 1, wherein the programming configuration further comprises a firmware program (54).

5. A system for programming a plurality of motor drives (10), comprising:
a workstation (44) configured to acquire a configuration file (50), wherein the configuration file (50) is indicative of a programming configuration of the plurality of motor drives (10), wherein the programming configuration includes one or more configurations relating to the basic operation of the motor drives and one or more application specific configurations, wherein the one or more configurations relating to the basic operation of the motor drives include one or more of communication protocols, particular motor drive regimes and techniques for driving solid state switches, and wherein the one or more application specific configurations include parameter designations, parameter settings and particular motion profiles; and
a plurality of motor drives (10) communicatively coupled to the workstation (44), said plurality of motor drives being adapted to receive three-phase power and to convert a fixed frequency input power to controlled frequency output power to be applied to a motor;
wherein the workstation (44) is configured to transfer the configuration file (50) to each of the plurality of motor drives (10), wherein transferring the configuration file to each of the plurality of motor drives (10) comprises adding to or replacing at least a portion of the programming configuration of each of the plurality of motor drives (10), and wherein the programming configuration comprises operator parameter settings.

6. The system of claim 5, wherein each of the plurality of motor drives (10) is configured to update the programming configuration associated with the motor drive (10) based on the configuration file (50) by adding to or replacing at least a portion of its respective programming configuration.

7. The system of claim 6, wherein each of the plurality of motor drives (10) includes a flash memory (32), wherein the programming configuration is stored on the flash memory (32).

8. The system of claim 6, wherein each of the plurality of motor drives (10) is configured to update the programming configuration by installing the programming configuration on each of the plurality of motor drives (10).

9. The system of claim 6, wherein the programming configuration further comprises a firmware program (54).

## Patentansprüche

1. Verfahren zum Programmieren einer Vielzahl von Motorantrieben (10), wobei die Vielzahl von Motorantrieben zum Aufnehmen von dreiphasigem Strom und Umwandeln eines Eingangsstroms mit fester Frequenz in einen Ausgangsstrom mit gesteuerter Frequenz zur Anwendung auf einen Motor angepasst ist, umfassend:
Erfassen einer Konfigurationsdatei (50) auf einer Workstation (44), wobei die Konfigurationsdatei (50) eine Programmierkonfiguration der Vielzahl von Motorantrieben (10) angibt, wobei die Programmierkonfiguration eine oder mehrere Konfigurationen in Bezug auf den Basisbetrieb der Motorantriebe und eine oder mehrere anwendungsspezifische Konfigurationen umfasst, wobei die eine oder mehreren Konfigurationen in Bezug auf den Basisbetrieb der Motorantriebe eine oder mehrere Kommunikationsprotokolle, insbesondere Motorantriebsregime und Verfahren zum Antreiben von Festkörperschaltern umfassen, und wobei die eine oder mehreren anwendungsspezifischen Konfigurationen Parameterbezeichnungen, Parametereinstellungen und bestimmte Bewegungsprofile umfassen;
kommunikatives Koppeln der Workstation (44) mit der Vielzahl von Motorantrieben (10); und
Übertragen der Programmierkonfiguration auf jeden der Vielzahl von kommunikativ mit der Workstation (44) gekoppelten Motorantriebe (10), wobei das Übertragen der Programmierkonfiguration auf jeden der Vielzahl von Motorantriebe (10) das Hinzufügen oder Ersetzen von wenigstens einem Teil der Programmierkonfiguration von jedem der Vielzahl von Motorantrieben (10) umfasst und wobei die Programmierkonfiguration Bedienerparametereinstellungen umfasst.

2. Verfahren nach Anspruch 1, wobei das Übertragen der Programmierkonfiguration auf jeden der Vielzahl von Motorantrieben (10) das Flashen der Programmierkonfiguration auf einem Flash-Speicher (32) von jedem der Vielzahl von Motorantrieben (10) umfasst.

3. Verfahren nach Anspruch 1, wobei das Übertragen der Programmierkonfiguration auf jeden der Vielzahl von Motorantrieben (10) das Installieren der Programmierkonfiguration auf jedem der Vielzahl von Motorantrieben (10) umfasst.

4. Verfahren nach Anspruch 1, wobei die Programmierkonfiguration ferner ein Firmware-Programm (54) umfasst.

5. System zum Programmieren einer Vielzahl von Motorantrieben (10), umfassend:
eine zum Erfassen einer Konfigurationsdatei (50) ausgebildete Workstation (44), wobei die Konfigurationsdatei (50) eine Programmierkonfiguration der Vielzahl von Motorantrieben (10) angibt, wobei die Programmierkonfiguration eine oder mehrere Konfigurationen in Bezug auf den Basisbetrieb der Motorantriebe und eine oder mehrere anwendungsspezifische Konfigurationen umfasst, wobei die eine oder mehreren Konfigurationen in Bezug auf den Basisbetrieb der Motorantriebe eine oder mehrere Kommunikationsprotokolle, insbesondere Motorantriebsregime und Verfahren zum Antreiben von Festkörperschaltern umfassen, und wobei die eine oder mehreren anwendungsspezifischen Konfigurationen Parameterbezeichnungen, Parametereinstellungen und bestimmte Bewegungsprofile umfassen; und
eine Vielzahl von kommunikativ mit der Workstation (44) gekoppelten Motorantrieben (10), wobei die Vielzahl von Motorantrieben zum Aufnehmen von dreiphasigem Strom und Umwandeln eines Eingangsstroms mit fester Frequenz in einen Ausgangsstrom mit gesteuerter Frequenz zur Anwendung auf einen Motor angepasst ist;
wobei die Workstation (44) zum Übertragen der Konfigurationsdatei (50) auf jeden der Vielzahl von Motorantrieben (10) ausgebildet ist, wobei das Übertragen der Konfigurationsdatei auf jeden der Vielzahl von Motorantrieben (10) das Hinzufügen oder Ersetzen wenigstens eines Teils der Programmierkonfiguration von jedem der Vielzahl von Motorantrieben (10) umfasst, und wobei die Programmierkonfiguration Bedienerparametereinstellungen umfasst.

6. System nach Anspruch 5, wobei jeder der Vielzahl von Motorantrieben (10) zum Aktualisieren der mit dem Motorantrieb (10) verknüpften Programmierkonfiguration auf Basis der Konfigurationsdatei (50) durch Hinzufügen oder Ersetzen wenigstens eines Teils der jeweiligen Programmierkonfiguration ausgebildet ist.

7. System nach Anspruch 6, wobei jeder der Vielzahl von Motorantrieben (10) einen Flash-Speicher (32) umfasst, wobei die Programmierkonfiguration auf dem Flash-Speicher (32) gespeichert wird.

8. System nach Anspruch 6, wobei jeder der Vielzahl von Motorantrieben (10) zum Aktualisieren der Programmierkonfiguration durch Installieren der Programmierkonfiguration auf jedem der Vielzahl von Motorantrieben (10) ausgebildet ist.

9. System nach Anspruch 6, wobei die Programmierkonfiguration ferner ein Firmware-Programm (54) umfasst.

## Revendications

1. Procédé de programmation d'une pluralité de commandes de moteur (10), ladite pluralité de commandes de moteur étant adaptée pour recevoir une alimentation triphasée et pour convertir une puissance d'entrée à fréquence fixe en une puissance de sortie à fréquence contrôlée à appliquer à un moteur, comprenant :
l'acquisition d'un fichier de configuration (50) sur une station de travail (44), dans lequel le fichier de configuration (50) est indicatif d'une configuration de programmation de la pluralité de commandes de moteur (10), dans lequel la configuration de programmation comprend une ou plusieurs configurations relatives au fonctionnement de base des commandes de moteur et une ou plusieurs configurations spécifiques à une application, dans lequel lesdites une ou plusieurs configurations relatives au fonctionnement de base des commandes de moteur comprennent un ou plusieurs protocoles de communication, régimes de commande de moteur particuliers et techniques pour piloter des commutateurs statiques, et dans lequel lesdites une ou plusieurs configurations spécifiques à une application comprennent des désignations de paramètre, des réglages de paramètres et des profils de mouvement particuliers ;
le couplage en communication de la station de travail (44) à la pluralité de commandes de moteur (10) ; et
le transfert de la configuration de programmation à chaque commande de la pluralité de commandes de moteur (10) couplées en communication à la station de travail (44), dans lequel le transfert de la configuration de programmation à chaque commande de la pluralité de commandes de moteur (10) comprend l'ajout ou le remplacement d'au moins une portion de la configuration de programmation de chaque commande de la pluralité de commandes de moteur (10), et dans lequel la configuration de programmation comprend des réglages de paramètres d'opérateur.

2. Procédé selon la revendication 1, dans lequel le transfert de la configuration de programmation à chaque commande de la pluralité de commandes de moteur (10) comprend le flashage de la configuration de programmation dans une mémoire flash (32) de chaque commande de la pluralité de commandes de moteur (10).

3. Procédé selon la revendication 1, dans lequel le transfert de la configuration de programmation à chaque commande de la pluralité de commandes de moteur (10) comprend l'installation de la configuration de programmation sur chaque commande de la pluralité de commandes de moteur (10).

4. Procédé selon la revendication 1, dans lequel la configuration de programmation comprend en outre un programme de micrologiciel (54).

5. Système pour programmer une pluralité de commandes de moteur (10), comprenant :
une station de travail (44) configurée pour acquérir un fichier de configuration (50), dans lequel le fichier de configuration (50) est indicatif d'une configuration de programmation de la pluralité de commandes de moteur (10), dans lequel la configuration de programmation comprend une ou plusieurs configurations relatives au fonctionnement de base des commandes de moteur et une ou plusieurs configurations spécifiques à une application, dans lequel lesdites une ou plusieurs configurations relatives au fonctionnement de base des commandes de moteur comprennent un ou plusieurs protocoles de communication, régimes de commande de moteur particuliers et techniques pour piloter des commutateurs statiques, et dans lequel lesdites une ou plusieurs configurations spécifiques à une application comprennent des désignations de paramètres, des réglages de paramètres et des profils de mouvement particuliers ; et
une pluralité de commandes de moteur (10) couplées en communication à la station de travail (44), ladite pluralité de commandes de moteur étant adaptée pour recevoir une alimentation triphasée et pour convertir une puissance d'entrée à fréquence fixe en une puissance de sortie à fréquence contrôlée à appliquer à un moteur ;
dans lequel la station de travail (44) est configurée pour transférer le fichier de configuration (50) à chaque commande de la pluralité de commandes de moteur (10), dans lequel le transfert du fichier de configuration à chaque commande de la pluralité de commandes de moteur (10) comprend l'ajout ou le remplacement d'au moins une portion de la configuration de programmation de chaque commande de la pluralité de commandes de moteur (10), et dans lequel la configuration de programmation comprend des réglages de paramètres d'opérateur.

6. Système selon la revendication 5, dans lequel chaque commande de la pluralité de commandes de moteur (10) est configurée pour actualiser la configuration de programmation associée à la commande de moteur (10) sur la base du fichier de configuration (50) en ajoutant ou en remplaçant au moins une portion de sa configuration de programmation respective.

7. Système selon la revendication 6, dans lequel chaque commande de la pluralité de commandes de moteur (10) comprend une mémoire flash (32), dans lequel la configuration de programmation est stockée sur la mémoire flash (32).

8. Système selon la revendication 6, dans lequel chaque commande de la pluralité de commandes de moteur (10) est configurée pour actualiser la configuration de programmation en installant la configuration de programmation sur chaque commande de la pluralité de commandes de moteur (10).

9. Système selon la revendication 6, dans lequel la configuration de programmation comprend en outre un programme de micrologiciel (54).
